# EUROPEAN PATENT SPECIFICATION

(11) **EP 1 043 662 B1**
(45) Date of publication and mention of the grant of the patent: **31.07.2002**
(21) Application number: 00107116.6
(22) Date of filing: 07.04.2000
(51) Int. Cl.: G06F 13/40

(54) **Apparatus and method for reconfiguring the pin assignments of one or more functional circuits in a microcontroller**
Vorrichtung und Verfahren zum Rekonfigurieren der Stiftenzuweisung von einer oder mehreren Funktionsschaltungen in einem Mikrokontroller
Appareil et procédé de reconfiguration de l'assignation de broches pour un ou plusieurs circuits fonctionnels dans un microcontrôleur

(30) Priority: 08.04.1999 US 288598
(43) Date of publication of application: 11.10.2000
(73) Proprietor: MICROCHIP TECHNOLOGY INC., Chandler, AZ 85224-6199 (US)
(72) Inventor: Boles, Edward Brian, Mesa, Arizona 85215 (US); Drake, Rodney J., Phoenix, Arizona 85044 (US); Triece, Joseph W., Phoenix, Arizona 85048 (US)
(74) Representative: Patry, Didier Marcel Pierre

(56) References cited:
- EP-A- 0 206 102
- US-A- 5 218 707
- US-A- 5 737 235

## Description

The present invention relates in general to microcontrollers, and more particularly to a microcontroller employing a multiplexer and configuration register that allow peripheral functionality to be switched between two different pins, enabling compatibility with previous devices and utilization of two peripherals simultaneously.

Recently there have been significant and rapid changes in technology taking place in the computer field. In particular, the speed of microprocessors and micrcontrollers is continually increasing. As a result of this rapid advancement in technology, manufacturers of minicomputer systems have found it necessary to upgrade their systems more frequently than in the past. This upgrading process includes introducing entirely new systems, retrofitting old systems, and sometimes a combination of both.

While customers desire the benefits associated with continually upgrading their computer systems, very few of them are willing, or able, to replace their entire system every time a new microprocessor is developed. Accordingly, chip manufacturers and computer system manufacturers have recognized the importance of making their microprocessors or microcontrollers compatible with previous devices. Compatibility has been achieved by several different approaches.

In one approach, compatibility has been achieved by emulation through microprogramming, *i.e.* by modifying portions of the operating system, or by utilizing similar architectures. While such compatibility has been achieved, these chips are still able to provide only a downward software compatibility. This means that the same software written for 8- or 16-bit microprocessor chips, for example, can be executed on 32-bit chips. However, as chip designs continue to evolve minicomputer manufacturers still will be required to maintain inventories of those different microprocessor chips utilized in new and old minicomputer designs. That is, downward software compatibility does not require downward hardware compatibility.

In fact, the opposite is usually the case. This means that in order for an older minicomputer system to take advantage of a new chip, it is necessary to redesign or retrofit the system to accept the new chip notwithstanding the compatibilities in chip pin assignments. The reason is that the new chip besides being faster usually includes new functionality. This can prove costly in terms of both equipment maintenance and inventory.

U.S. Patent No. 4,677,548 discloses a chip which is usable in both new and older systems without requiring that changes be made to the older systems. The chip disclosed in this patent includes compatibility circuits that connect to a number of pins that are unused in the chip that it replaces in an existing computer system. The compatibility circuits connect to those internal parts of the new chip that contain the newly added or altered levels of functionality. In this solution, the new chip is installed in the existing computer system just as the prior chip. When so installed, the compatibility circuits enable the new chip to operate in the same manner as the replaced chip but generally at higher speeds. When the new chip is installed in the system for which it was designed, the compatibility circuits enable the chip to operate with a selectable level of new functionality. While this solution enables backward compatibility, it fails to enable multiple uses of one or more pins, and thus does not maximize the use of the input/output pins.

U.S. Patent No. 5,375,209 on the other hand discloses a device that enables multiple uses of one or more pins. This patent discloses a microprocessor that has a plurality of input/output pins and a processing circuit coupled to the input/output pins. The patent further discloses circuitry, which is provided for selectively decoupling the processing circuitry from one or more of the input/output pins, so that pins associated with enhanced features may be decoupled to provide compatibility with a desired microprocessor feature. Thus, this patent discloses a method and apparatus for switching between two different functionalities by disabling one functionality and enabling another. This solution, however, is limited in that it does not disclose moving functionality from one pin to another, and thus does not enable simultaneous use of two different peripherals capable of functioning on a single pin.

EP 0 206 102 discloses an externally programmable interface to selectively couple the terminals of an electronic system to desired circuit locations within the system.

The present invention overcomes the above-identified problems as well as other shortcomings and deficiencies of existing technologies by providing an electronic device with processing circuitry and a configurable pin arrangement that has a first pin, second pin, a functional circuit, and a multiplexer. The multiplexer is operable to receive a flag, couple the functional circuit to the first pin when the flag is equal to 1; and couple the functional circuit to the second pin when said flag is equal to 0. In the preferred embodiment, a configuration register is also provided that stores the flag and is connected to the multiplexer.

In one alternate embodiment, the first pin is coupled to another functional circuit when the flag is equal to 0. This permits the two functional circuits to operate simultaneously. In another alternate embodiment, the multiplexer is operable to couple the functional circuit to any input/output pin on the electronic device.

In yet another alternate embodiment of the present invention, a method of configuring pins on an electronic device that is capable of operating in multiple modes is provided. The preferred method includes the steps of assigning a functional circuit to a first pin as a default setting in one operating mode, and reassigning the functional circuit to a second pin in an alternate operating mode. The method may further include the step of assigning another functional circuit to the first pin in the alternate operating mode, so that the two functional circuits can operate simultaneously in the alternate operating mode. The reassigning step can be performed either when the electronic device is initially programmed or during normal operation of the electronic device.

Additional embodiments will be clear to those skilled in the art upon reference to the detailed description and accompanying drawings.
Figure 1 is a schematic block diagram of one embodiment of the present invention illustrating the circuitry that enables a user to move the functionality associated with one functional circuit from one pin to another;
Figure 2 is a schematic block diagram of another embodiment of the present invention illustrating the circuitry that enables a user to reassign one functional circuit from one pin to another and assign another functional circuit to the one pin so as to enable both functional circuits to operate simultaneously;
Figure 3 is a schematic block diagram of another embodiment of the present invention illustrating the circuitry that enables a user to move the functionality associated with one functional circuit from one pin to any other of a number of pins on the microcontroller; and
Figure 4 is a schematic block diagram of another embodiment of the present invention illustrating the circuitry that enables a user to assign and reassign multiple functional circuits to any one of a number of pins on the microcontroller.

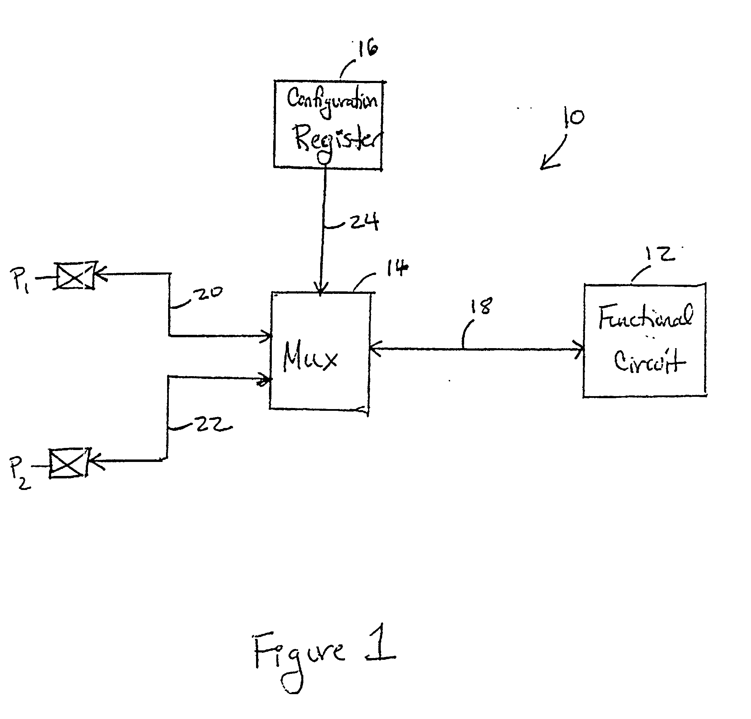

Turning now to the drawings, and referring specifically to Figure 1, a portion of the circuitry of a microcontroller according to the present invention is shown generally by reference numeral 10. The circuit 10 includes a functional circuit 12, *e.g.,* a CCP2 (Capture, Compare and PWM) module, a timer 1, timer 3, USART, or any other functional circuit. The functional circuit 12 connects to the outside world through either pin P1 or pin P2. Pins P1 and P2 are general purpose input/output pins.

The circuit 10 further includes a multiplexer 14, which connects the functional circuit 12 to pin P1 or pin P2, in response to a flag received from a configuration register 16. The multiplexer 14 is connected to the functional circuit 12 via communication line 18; pin P1 via communication line 20; pin P2 via communication line 22; and configuration register 16 via communication line 24. The multiplexer 14 operates to connect the functional circuit 12 to the pin P1, if the flag that it receives from the configuration register 16 is a "1". The multiplexer 14 further operates to connect the functional circuit 12 to the pin P2 if the flag that it receives from the configuration register 16 is a "0". Thus, by employing the multiplexer 14 and configuration register 16, circuit 10 enables the user to move the functionality associated with functional circuit 12 from one pin to another.

The configuration register 16 is a non-volatile memory element, preferably a single bit EPROM (Erasable Programmable Read Only Memory) or flash memory device. It stores the flag, which in the embodiment of Figure 1 is either a "0" or a "I". In the default setting, the flag is equal to "1". The default setting is set by the manufacturer and enables the microcontroller to be used in prior devices, *i.e*., it makes the microcontroller backward compatible. Put another way, the microcontrollers according to the present invention are general purpose microcontrollers that have applicability in a whole host of applications, *e.g.*, bread makers, anti-lock brakes, keyless entry, etc. Often times it is desired to replace the microcontroller in such applications due to an advance in microcontrollers that will enhance the operation of the underlying application. In such a situation, it is desired to have the new and improved microcontroller, such as the one according to the present invention, be compatible with the operation of the prior microcontroller in the system in which it is to be used. It is in this case where the default setting would be utilized.

For example, in one application the functional circuit 12 in the prior microcontroller (which the microcontroller of the present invention is intended to replace) may have received its input/output from pin P1. In this case, the user will not desire to change the default setting, because the default flag of "1" connects the functional circuit 12 to pin P1. Thus, as pointed out above, the default setting makes the microcontroller of the present invention backward compatible.

In the event that the user desires to move the functionality associated with functional circuit 12 from pin P1 to pin P2, the user merely needs to change from the default setting. This is accomplished simply by changing the flag that is stored in the configuration register 16 from a "1" to a "0". As those of ordinary skill in the art will appreciate, the flag is changed in the configuration register 16 by executing one or more program steps, including at least one table write. Because the programming memory of the configuration register 16 in the preferred embodiment is 16 bits wide and the table latch is only 8 bits, it will take two table writes to change the flag from a "1" to a "0". However, the particular steps involved in programming the configuration register 16 do not form a part of the present invention.

In one aspect of the present invention, the default setting is changed during the programming mode, *i.e.,* when the user configures the microcontroller. During this mode, the configuration register 16 is programmed (or reprogrammned) by instructions that are received from outside of the microcontroller. Alternatively, the configuration register 16 may be reprogrammed during normal operation of the microcontroller by instructions received internally from the processing circuitry of the microcontroller. This latter arrangement allows for dynamic reconfiguration of the microcontroller.

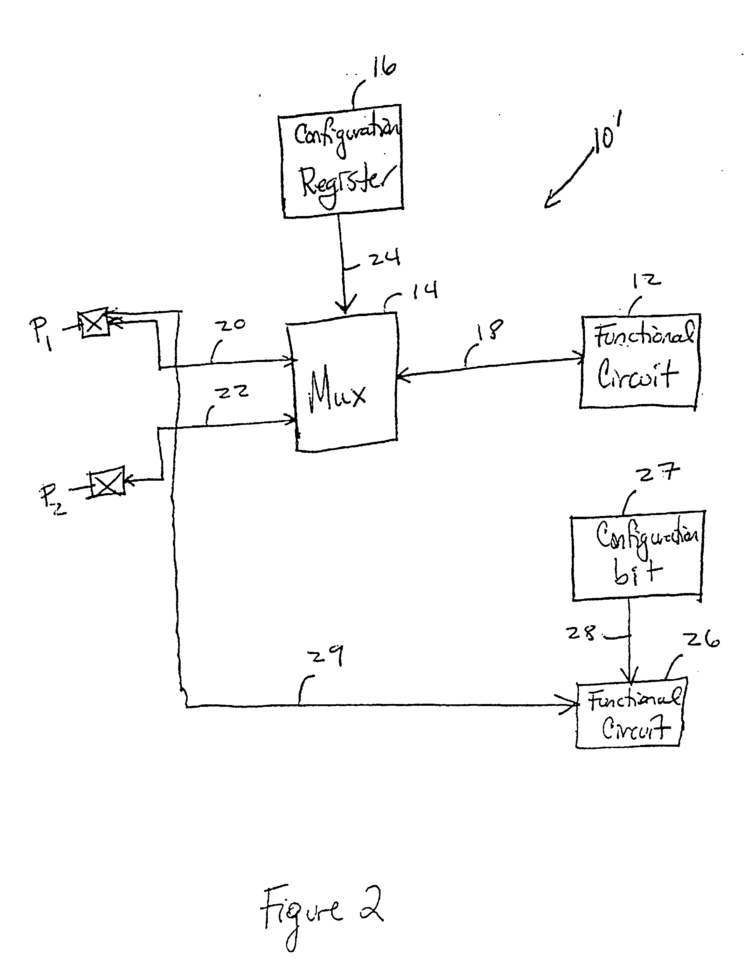

In another embodiment of the present invention, a second functional circuit 26, *e.g*., the internal circuitry associated with a timer oscillator, is provided, as shown in Figure 2. The circuit 10' is designed so that when the functionality associated with the functional circuit 12 is moved from pin P1 to pin P2, the functionality associated with the functional circuit 26 can be connected to the pin P1. This is accomplished using a configuration bit 27, which is preferably a RAM bit. However, in an alternate embodiment of the present invention, the configuration bit 27 may be a single bit EPROM, which would enable reconfiguration to be performed during a programming mode. The configuration bit 27 stores an instruction (a flag), which is communicated to the functional circuit 26 via communication line 28. When the flag is equal to "0", the functional circuit 26 is disconnected from the pin P1. When the flag is equal to "1", the functional circuit 26 is connected to the pin P1 via communication line 29.

In the default setting, the flag is equal to "0", *i.e.,* in this setting the functional circuit 26 is not operational. During normal operation, however, the value of the flag stored in the configuration bit 26 can be changed, so as to connect (or disconnect) the functional circuit 26 to (from) the pin P1. The steps for accomplishing this are described above. Again, however, the details of this method are not critical to the present invention.

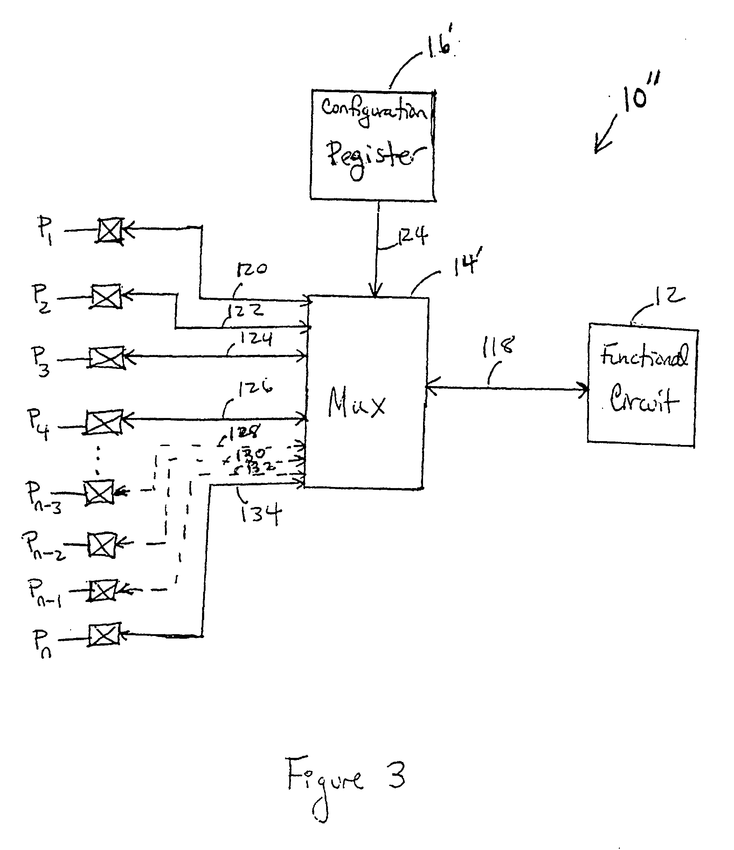

In an alternate embodiment of the present invention, the functionality associated with the functional circuit 12 can be moved from pin P1 to any other general purpose input/output pin P2 through Pn, where n is the total number of general purpose input/output pins on the microcontroller, as shown in Figure 3. In this embodiment, the multiplexer 14' has n outputs and the configuration register 16' has x bits, where 2^{x} ≥ n. For example, in the case where the microcontroller has 40 pins, 33 of which are general purpose input/output pins, n = 33. In this case, the multiplexer 14' has 33 outputs and the configuration register 16' would have 6 bits. The multiplexer 14' is connected to the functional circuit 12 via communication line 118, the configuration register via communication line 124, and to pins P1 through Pn via communication lines 120 through 134.

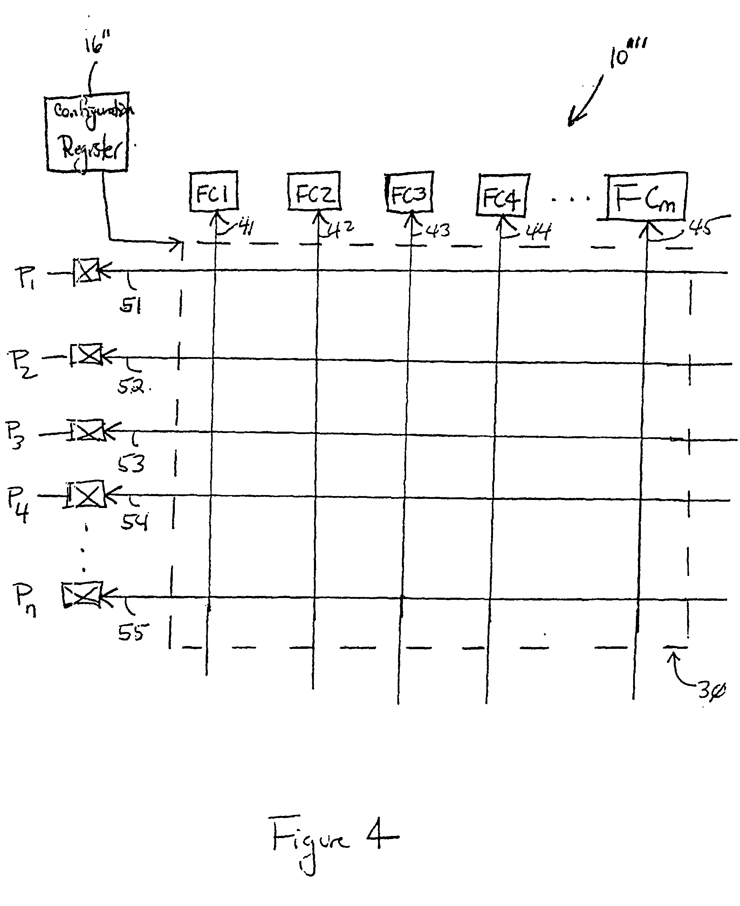

In yet another alternate embodiment, the present invention is extended to multiple functional circuits. In this embodiment, the multiple functional circuits, designated by reference indications FC1, FC2, FC3, ... FCm, can be connected to any one of the general purpose input/output pins P1 through Pn, as shown in Figure 4. This is accomplished through the use of a cross-point switch 30, which in turn receives a flag from configuration register 16", which like configuration register 16' is preferably a multi-bit EPROM. In one possible variation of this embodiment, when the flag carries a certain address, *e.g*., "0000" in a 4 pin by 4 functional circuit array, the cross-point switch 30 connects the functional circuit FC1 to pin P1. This connection is made via communication lines 41 and 51. In another example of this variation, when the flag is "0001" the cross-point switch 30 connects the functional circuit FC1 to pin P2. This connection is made via communication lines 41 and 52. In yet another example of this variation, when the flag is "0100" the cross-point switch 30 connects the functional circuit FC2 to pin P1. This latter connection is made via communication lines 42 and 51. As those of ordinary skill in the art will appreciate, there are multiple variations of this embodiment of the present invention.

As those of ordinary skill in the art will also appreciate, other embodiments of the present invention are possible. In yet another alternate embodiment, a plurality of multiplexers is employed to connect multiple functional circuits to any one of the general-purpose input/output pins on the microcontroller. In yet another aspect of the present invention, one or more demultiplexers can be used to connect a plurality of functional circuits to a single input/output pin.

Accordingly, as those of ordinary skill in the art will appreciate, the present invention is well adapted to carry out the ends and advantages mentioned, as well as others inherent therein. While the present invention has been depicted, described, and is defined by reference to particular preferred embodiments of the invention, such references do not imply a limitation on the invention, and no such limitation is to be inferred. The invention is capable of considerable modification, alternation, and equivalents in form and function, as will occur to those ordinarily skilled in the pertinent arts. The depicted and described preferred embodiments of the invention are exemplary only, and are not exhaustive of the scope of the invention. For example, while the invention is described as having applicability to microcontrollers, it is intended to have application to other integrated circuits, including, but not limited to, any microprocessor.

## Claims

1. A microcontroller having a configurable pin arrangement, said microcontroller comprising:
(a) a first pin (P1) ;
(b) a second pin(P2);
(c) a functional circuit (12);
(d) a central processing unit being coupled with said functional unit;
(e) programming means being coupled with said central processing unit; and
(f) a multiplexer (14) operable to: (i) receive a flag from said programming means, (ii) couple the functional circuit to the first pin when the flag is equal to 1; and (iii) couple the functional circuit to the second pin when said flag is equal to 0,
wherein said programming means comprise a configuration register (16) that stores the flag and is connected to the multiplexer.

2. The microcontroller according to claim 1, wherein the configuration register is selected from the group consisting of a single bit EPROM and flash memory.

3. The microcontroller according to one of the preceding claims, wherein the functional circuit is selected from the group consisting of a Capture, Compare and PWM module, timer 1, timer 3, USART.

4. The microcontroller according to one of the preceding claims, wherein the first pin is coupled to another functional circuit when said flag is equal to 0.

5. The microcontroller according to claim 4, further comprising a configuration bit that stores a flag equal to 0 or 1, and is connected to the another functional circuit.

6. The microcontroller according to claim 5, wherein when the flag stored in the configuration bit is equal to 0 the microcontroller is in a default state, which makes the microcontroller compatible with prior microcontrollers.

7. The microcontroller according to claim 5, wherein the configuration bit is selected from the group consisting of a RAM bit and a single bit EPROM.

8. The microcontroller according to claim 5, wherein the another functional circuit is connected to the first pin when the flag stored in the configuration bit is equal to 1.

9. The microcontroller according to claim 8, wherein when the flag in the configuration bit is equal to 1, the two functional circuits can operate simultaneously.

10. The microcontroller according to claim 4, wherein the another functional circuit is a timer oscillator.

11. The microcontroller according to one of the preceding claims, wherein the multiplexer is operable to couple the functional circuit to any input/output pin on the microcontroller.

12. The microcontroller according to one of the preceding claims; further comprising:
a plurality of functional circuits;
a plurality of pins; and
wherein said multiplexer is integrated in a cross-point switch operable to connect any one of the plurality of functional circuits to any one of the plurality of pins.

13. The microcontroller according to claim 12, further comprising a configuration register that stores a flag that is communicated to the cross-point switch, which instructs the cross-point switch to connect a particular functional circuit to a particular pin.

## Patentansprüche

1. Mikrokontroller mit einer konfigurierbaren Anschlussstiftanordnung, wobei der Mikrokontroller aufweist:
(a) einen ersten Anschlussstift (F1);
(b) einen zweiten Anschlussstift (F2);
(c) eine Funktionsschaltung (12);
(d) eine zentrale Verarbeitungseinheit, die an die Funktionseinheit gekoppelt ist;
(e) Programmiermittel, die an die zentrale Verarbeitungseinheit gekoppelt sind; und
(f) einen Multiplexer (14), der dazu ausgebildet ist: (i) einen Merker (Flag) von den Programmiermitteln zu empfangen, (ii) die Funktionsschaltung an den ersten Anschlussstift zu koppeln, wenn der Merker gleich 1 ist; und (iii) die Funktionsschaltung an den zweiten Anschlussstift zu koppeln, wenn der Merker gleich 0 ist, wobei die Programmiermittel ein Konfigurationsregister (16) enthalten, das den Merker speichert und das an den Multiplexer angeschlossen ist.

2. Mikrokontroller nach Anspruch 1, bei dem das Konfigurationsregister ein Ein-Bit-EPROM oder Flashspeicher ist.

3. Mikrokontroller nach einem der vorangehenden Ansprüche, bei dem die Funktionsschaltung ein Erfassungs-, Vergleichs- und PWM-Modul, ein Timer 1, ein Timer 3 oder ein USART ist.

4. Mikrokontroller nach einem der vorangehenden Ansprüche, bei dem der Anschlussstift an eine andere Funktionsschaltung gekoppelt ist, wenn der Merker gleich 0 ist.

5. Mikrokontroller nach Anspruch 4, der weiterhin ein Konfigurationsbit aufweist, das einen Merker, der gleich 0 oder 1 ist, speichert und das an eine andere Funktionsschaltung angeschlossen ist.

6. Mikrokontroller nach Anspruch 5, bei dem sich der Mikrokontroller in einen vorgegebenen Zustand befindet, wenn der in dem Konfigurationsbit gespeicherte Merker gleich 0 ist, was den Mikrokontroller kompatibel mit früheren Mikrokontrollern macht.

7. Mikrokontroller nach Anspruch 5, bei dem das Konfigurationsbit ein RAM-Bit oder ein Ein-Bit-EPROM ist.

8. Mikrokontroller nach Anspruch 5, bei dem eine andere Funktionsschaltung mit dem ersten Anschlussstift verbunden ist, wenn der in dem Konfigurationsbit gespeicherte Merker gleich 1 ist.

9. Mikrokontroller nach Anspruch 8, bei dem die zwei Funktionsschaltungen gleichzeitig in Betrieb sein können, wenn das Konfigurationsbit gleich 1 ist.

10. Mikrokontroller nach Anspruch 4, bei dem die andere Funktionsschaltung ein Timer-Oszillator ist.

11. Mikrokontroller nach einem der vorangehenden Ansprüche, bei dem der Multiplexer dazu ausgebildet ist, die Funktionsschaltung an einen beliebigen Eingangs/Ausgangs-Anschlussstift an dem Mikrokontroller zu koppeln.

12. Mikrokontroller nach einem der vorangehenden Ansprüche, der weiterhin aufweist:
mehrere Funktionsschaltungen;
mehrere Anschlussstifte; und
wobei der Multiplexer in einer Koppelpunktvermittlung integriert ist, die dazu ausgebildet ist, eine beliebige von mehreren Funktionsschaltungen an einen beliebigen von mehreren Anschlussstiften anzuschließen.

13. Mikrokontroller nach Anspruch 12, der weiterhin ein Konfigurationsregister aufweist, das einen Merker speichert, der der Koppelpunktvermittlung mitgeteilt wird und welcher die Koppelpunktvermittlung anweist, eine bestimmte Funktionsschaltung mit einem bestimmten Anschlussstift zu verbinden.

## Revendications

1. Microcontrôleur ayant une disposition de broches configurable, ledit microcontrôleur comprenant :
(a) une première broche (P1) ;
(b) une deuxième broche (P2) ;
(c) un circuit fonctionnel (12) ;
(d) une unité centrale de traitement reliée à ladite unité fonctionnelle ;
(e) des moyens de programmation reliés à ladite unité centrale de traitement et ;
(f) un multiplexeur (14) apte à fonctionner pour : (i) recevoir un drapeau desdits moyens de programmation, (ii) relier le circuit fonctionnel à la première broche quand ledit drapeau est égal à 1 ; et (iii) relier le circuit fonctionnel à la deuxième broche quand ledit drapeau est égal à 0,
dans lequel lesdits moyens de programmation comprennent un registre de configuration (16) qui stocke le drapeau et qui est connecté au multiplexeur.

2. Microcontrôleur selon la revendication 1, dans lequel le registre de configuration est sélectionné parmi le groupe comprenant une mémoire morte programmable et effaçable (EPROM) à bit unique et une mémoire flash.

3. Microcontrôleur selon l'une quelconque des revendications précédentes, dans lequel le circuit fonctionnel est sélectionné parmi le groupe comprenant un module de Capture, de Comparaison et de modulation de largeur d'impulsion (PWM), un circuit temporisateur 1, un circuit temporisateur 3, un circuit émetteur/récepteur synchrone/asynchrone universel (USART).

4. Microcontrôleur selon l'une quelconque des revendications précédentes, dans lequel la première broche est reliée à un autre circuit fonctionnel quand le drapeau est égal à 0.

5. Microcontrôleur selon la revendication 4, comprenant en outre un bit de configuration qui stocke le drapeau égal à 1 ou 0, et qui est relié à un autre circuit fonctionnel

6. Microcontrôleur selon la revendication 5, dans lequel quand le drapeau stocké dans le bit de configuration est égal à 0, le microcontrôleur est dans un état par défaut, ce qui rend le microcontrôleur compatible avec des microcontrôleurs antérieurs.

7. Microcontrôleur selon la revendication 5, dans lequel le bit de configuration est sélectionné parmi le groupe comprenant un bit de mémoire vive (RAM) et une mémoire morte programmable et effaçable (EPROM) à bit unique.

8. Microcontrôleur selon la revendication 5, dans lequel l'autre circuit fonctionnel est connecté à la première broche quand le drapeau stocké dans le bit de configuration est égal à 1.

9. Microcontrôleur selon la revendication 8, dans lequel quand le drapeau dans le bit de configuration est égal à 1, les deux circuits fonctionnels peuvent fonctionner simultanément.

10. Microcontrôleur selon la revendication 4, dans lequel l'autre circuit fonctionnel est un oscillateur temporisateur.

11. Microcontrôleur selon l'une des revendications précédentes dans lequel le multiplexeur est apte à fonctionner pour relier le circuit fonctionnel à toute broche d'entrée/sortie quelconque du microcontrôleur.

12. Microcontrôleur selon l'une des revendications précédentes, comprenant en outre :
une pluralité de circuits fonctionnels ;
une pluralité de broches ; et
dans lequel ledit multiplexeur est intégré dans un dispositif de commutation pour point de connexion apte à fonctionner pour connecter un circuit quelconque de ladite pluralité de circuits à l'une quelconque des broches de ladite pluralité.

13. Microcontrôleur selon la revendication 12, comprenant en outre un registre de configuration qui stocke un drapeau qui est communiqué au dispositif de commutation pour point de connexion, qui commande le dispositif de commutation pour point de connexion pour qu'il connecte un circuit fonctionnel particulier à une broche particulière.
